(19) Europäisches Patentamt
European Patent Office
Office européen des brevets

(11) EP 0 561 809 B1

(12) EUROPÄISCHE PATENTSCHRIFT

(45) Veröffentlichungstag und Bekanntmachung des Hinweises auf die Patenterteilung:
13.03.1996 Patentblatt 1996/11

(51) Int Cl.⁶: **H01L 29/06**, H01L 27/082

(21) Anmeldenummer: 91919865.5

(22) Anmeldetag: 19.11.1991

(86) Internationale Anmeldenummer:
PCT/DE91/00909

(87) Internationale Veröffentlichungsnummer:
WO 92/10855 (25.06.1992 Gazette 1992/14)

(54) **MONOLITHISCH INTEGRIERTE HALBLEITERANORDNUNG**

MONOLITHIC INTEGRATED SEMICONDUCTOR DEVICE

DISPOSITIF INTEGRE MONOLITHIQUE A SEMI-CONDUCTEURS

(84) Benannte Vertragsstaaten:
DE ES FR GB IT NL SE

(30) Priorität: 12.12.1990 DE 4039662

(43) Veröffentlichungstag der Anmeldung:
29.09.1993 Patentblatt 1993/39

(73) Patentinhaber: ROBERT BOSCH GMBH
D-70442 Stuttgart (DE)

(72) Erfinder:
• MICHEL, Hartmut
  W-7410 Reutlingen (DE)
• FLOHRS, Peter
  W-7410 Reutlingen 11 (DE)
• GOERLACH, Alfred
  W-7410 Kusterdingen (DE)

(56) Entgegenhaltungen:
WO-A-83/02528

• IBM TECHNICAL DISCLOSURE BULLETIN, Bd. 19, Nr. 2, Juli 1976, NEW YORK US, Seiten 478-479; C.G. JAMBOTKAR : 'Spaced field plate for increasing planar junction breakdown voltage'

## Beschreibung

Stand der Technik

Die Erfindung betrifft eine monolithisch integrierte Halbleiteranordnung gemäß der Gattung des Hauptanspruchs.

Es sind Halbleiteranordnungen bekannt, die zur Begrenzung der Durchbruchsspannung von Transistoren, insbesondere von Darlington-Transistoren, über dem Raumladungsgebiet eine durch Oxid getrennte metallische Deckelektrode besitzen, die mittels eines Spannungsteilers auf ein bestimmtes Potential zwischen Basis und Kollektor gelegt wird. Die Durchbruchsspannung wird im wesentlichen durch das Spannungspotential der Deckelektrode und durch die Dicke des Oxides bestimmt.

Aus der US-PS 4 618 875 ist eine derartige Darlington-Transistorschaltung bekannt, bei der die Deckelektrode an der Oberfläche des Substrats ausgebildet ist und sich über zwei im Abstand angeordnete, entgegengesetzt dotierte Zonen erstreckt. Die maximal erreichbare Durchbruchsspannung entspricht dem Spannungswert, der sich aus der Summe von Anreichungsdurchbruchsspannung und Verarmungsdurchbruchsspannung ergibt. Dabei ist jedoch zu berücksichtigen, daß die in Planarprozessen üblicherweise verwendeten termischen Oxide nicht beliebig dick gemacht werden können, weshalb die mit einer solchen Anordnung maximal erreichbare Spannung begrenzt ist.

Vorteile der Erfindung

Eine monolithisch integrierte Halbleiteranordnung mit den Merkmalen des Hauptanspruchs hat demgegenüber den Vorteil, daß die Durchbruchsspannungen nur von der Verarmungsdurchbruchsspannung und von dem Teilerverhältnis des Spannungsteilers abhängig sind, der an seinem Abgriff mit der Deckelektrode verbunden ist und deren Spannungspotential bestimmt. Bei einem npn-Transistor überdeckt die Deckelektrode das Kollektorgebiet nicht mehr vollständig, sondern nur noch einen Übergangsbereich des niedrig n-dotierten Kollektorgebiets und den Randbereich einer daran angrenzenden hoch n-dotierten Zone. Die Deckelektrode reicht bei einem npn-Transistor nicht bis zum p-dotierten Basisgebiet. Dagegen wird bei einem pnp-Transistor gerade der Übergangsbereich des Basisgebiets von der Deckelektrode überdeckt, die in diesem Fall nicht bis zu der im Abstand befindlichen p-dotierten Zone reicht.

Gemäß einer Weiterbildung der Erfindung kann auch der pn-Übergang zwischen dem hochohmigen Kollektorgebiet und dem p-dotierten Basisgebiet bei einer als Transistor ausgebildeten Halbleiteranordnung mittels einer zweiten Deckelektrode passiviert sein. Die zweite Deckelektrode ist mit der Basismetallisierung des Transistors identisch. Es ist aber auch möglich, diese zweite Deckelektrode auf Emitterpotential zu legen, wobei in jedem Fall sichergestellt sein muß, daß die beiden Deckelektroden galvanisch getrennt sind, so daß kein Anreicherungsdurchbruch auftreten kann. Auch bei dieser Ausführung ist die maximal erreichbare Durchbruchsspannung nur von der Verarmungdurchbruchsspannung und von dem Spannungsteilerverhältnis des Spannungsteilers abhängig, an dessen Abgriff die vom Basisgebiet entfernte erste Deckelektrode angeschlossen ist.

Das Spannungspotential für die Deckelektrode wird vorzugsweise mittels eines monolithisch integrierten Spannungsteilers eingestellt. Die Ausführung eines derartigen Spannungsteilers ist aus der EP-PS 179 099 sowie aus der US-PS 4 695 867 bekannt.

Um eine Temperaturkompensation der Durchbruchsspannung zu erreichen, können die den Spannungsteiler bildenden Widerstände aus unterschiedlich hoch dotiertem Silizium gebildet werden.

Sehr einfach lassen sich die Teilerwiderstände als streifenförmige Zonen integrieren, die ausgenommen an Anschlußpunkten mit einer Passivierungsschicht bedeckt sind. An den Anschlußpunkten kann durch Aufbringen einer Metallschicht die erforderliche Kontaktierung beispielsweise am Abgriff des Spannungsteilers erfolgen.

Vorteilhafte Weiterbildungen der Erfindung sind in den Unteransprüchen gekennzeichnet.

Zeichnung

Die Erfindung wird nachfolgend anhand einer herkömmlichen Halbleiteranordnung und weiterer erfindungsgemäßer Ausführungsformen näher erläutert.
Es zeigen:

Figur 1 eine herkömmliche Halbleiteranordnung,

Figur 2 eine erste erfindungsgemäße Anordnung mit einer einen nn-Übergang überdeckenden Deckelektrode,

Figur 3 eine erfindungsgemäße Anordnung mit einer zusätzlichen Basisdeckelektrode bei einem npn-Transistor,

Figur 4 die Abhängigkeit der Durchbruchsspannung einer erfindungsgemäßen Anordnung vom Spannungsteilerverhältnis,

Figur 5 eine erfindungsgemäße Halbleiteranordnung, die als pnp-Transistor ausgebildet ist.

Figur 6 die Draufsicht auf eine erfindungsgemäße Halbleiteranordnung mit Deckelektrode und integrierten Spannungsteiler, wobei der basisseitige Teil des Spannungsteilers nicht unter Deckelektrodenmetall liegt,

Figur 7 die Draufsicht auf eine erfindungsgemäße Halbleiteranordnung, bei der eine geringere Stromabhängigkeit der Durchbruchsspannung erreicht ist, und

Figur 8 die Draufsicht auf eine erfindungsgemäße Halbleiteranordnung mit einer zusätzlichen Basisdeckelektrode, wobei der basisseitige Teil des Spannungsteilers nicht unter Metall liegt.

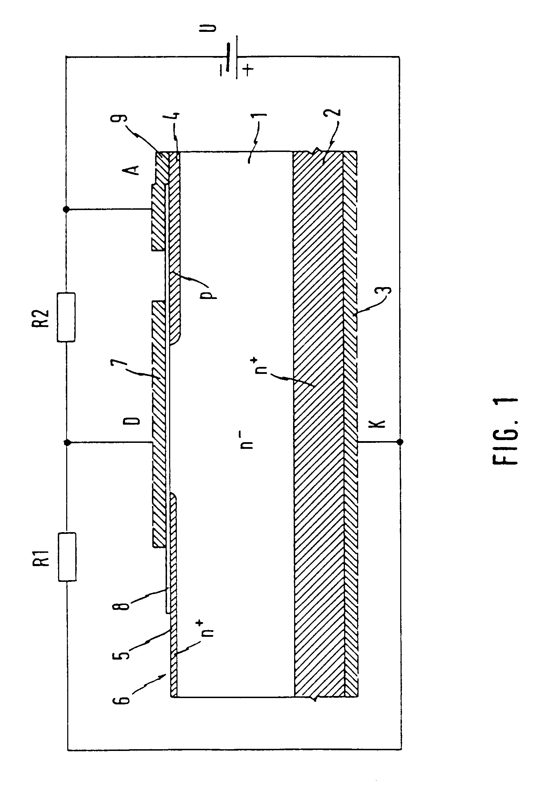

Figur 1 zeigt eine in Planartechnik ausgeführte Anordnung, wie sie in der DE-PS 32 275 36 beschrieben ist. Das Ausgangsmaterial für die Herstellung ist Silizium, das im oberen Bereich 1 schwach (n⁻) und auf der Unterseite 2 hoch (n⁺) dotiert ist. Die Unterseite ist mit Metall 3 kontaktiert und wird mit K bezeichnet. Die p- und n⁺-Zonen 4, 5 auf der Hauptoberfläche 6 sind in bekannter Weise mittels Fototechnik, Dotierung und Diffusion hergestellt. Die p-Zone 4 dient als Transistorbasis und wird mit A bezeichnet. Der Übersichtlichkeit halber ist die bei einem bipolaren Transistor in die Basiszone 4 eingebrachte n⁺ -dotierte Emitterzone nicht gezeichnet. Die n⁺-Zone 5 mit der Ausbuchtung 5A kann gleichzeitig mit der Emitterdotierung eindiffundiert werden. Sie begrenzt die sich im n⁻ -Gebiet ausbreitende Raumladungszone auf Gebiete unter einer von einer Metallisierung 7 gebildeten Deckelektrode D, wenn zwischen A und K eine Sperrspannung U angelegt wird. Die Deckelektrode D ist mittels Oxid 8 von den Zonen 1, 4 und 5 galvanisch getrennt. Das Basisgebiet 4 ist mit Metall 9 kontaktiert. Die Deckelektrode D wird an einem durch Widerstände R1 und R2 gebildeten, auch monolithisch integrierbaren Spannungsteiler zwischen A und K angeschlossen. Die im Fall von R1 bzw. R2 = 0 zwischen A und K erreichbaren Durchbruchsspannungen sind U2 bzw. U1, wobei U2 die Anreicherungs- und U1 die Verarmungsdurchbruchsspannung der durch die Deckelektrode D, durch das darunterliegende Oxid 8 und durch das Silizium gebildete MOS - Struktur ist.

Die maximal erreichbare Durchbruchsspannung ist U1 + U2, wenn R1 : R2 = U1 : U2 erfüllt ist. Da die in Planarprozessen üblicherweise verwendeten thermischen Oxide nicht beliebig dick gemacht werden können, ist die mit einer solchen Anordnung maximal erzielbare Spannung begrenzt.

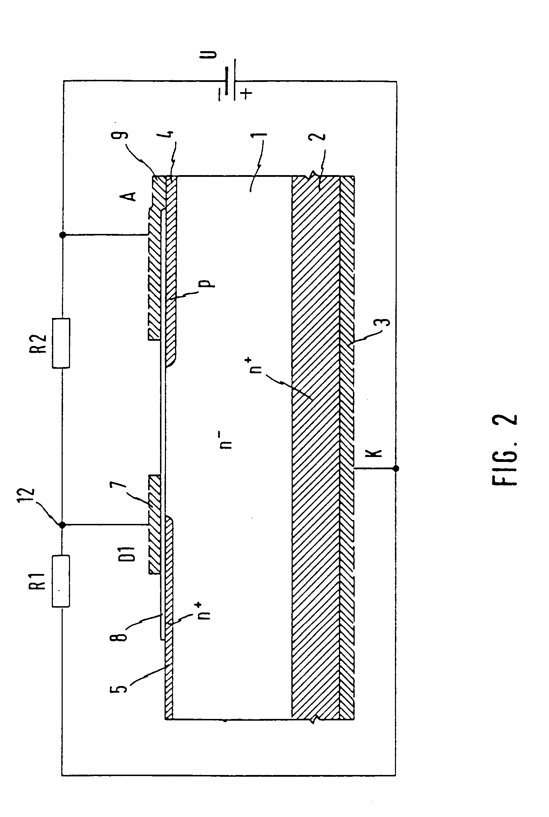

In Figur 2 ist eine erfindungsgemäße Anordnung mit einer Deckelektrode D1 gezeigt, die das hochohmige, schwach dotierte (n⁻) Kollektorgebiet 1 nur im Bereich einer hochdotierten (n⁺) Zone 5 überdeckt. Die Deckelektrode D1 überdeckt somit den n⁺n⁻-Übergangsbereich und befindet sich in deutlichem Abstand von der p-Zone 4, die als Basisgebiet eines npn-Transistors dient. Der Übersichtlichkeit wegen wurde die Emitterdotierung im Bereich des Basisgebiets 4 nicht eingezeichnet. Aus der bereits genannten US-PS 4 618 875 kann die Ausbildung der Emitterdotierungen entnommen werden.

Die Deckelektrode D1 ist durch den Abgriff 12 an den durch die Widerstände R1 und R2 gebildeten Spannungsteiler angeschlossen. Der Spannungsteiler teilt die zwischen den Anschlußpunkten A und K liegende Versorgungsspannung U entsprechend seinem Teilerverhältnis.

Beim Anlegen einer Sperrspannung zwischen A und K ist die für den Fall R2 = 0 zwischen A und K erreichbare Durchbruchsspannung U1, wobei U1 mit der Verarmungsdurchbruchsspannung bei Verwendung der Deckelektrode D gemäß Figur 1 identisch ist. Die Durchbruchsspannung U zwischen A und K ist die von dem durch die Widerstände R1 und R2 gebildeten Spannungsteiler hochtransformierte Verarmungsdurchbruchsspannung. Man erhält:

$$U = U1 * (1 + R2/R1) \qquad (1)$$

Die maximal erreichbare Durchbruchsspannung U zwischen A und K ist mehr durch den Anreicherungsdurchbruch U2 beeinflußt. Die obere Grenze der Durchbruchsspannung U ist nur noch von der Sperrfähigkeit des pn-Überganges 1, 4 bzw. von der Kollektor-Emitter-Durchbruchsspannung $U_{CEO}$ bei offener Basis des npn-Transistors begrenzt.

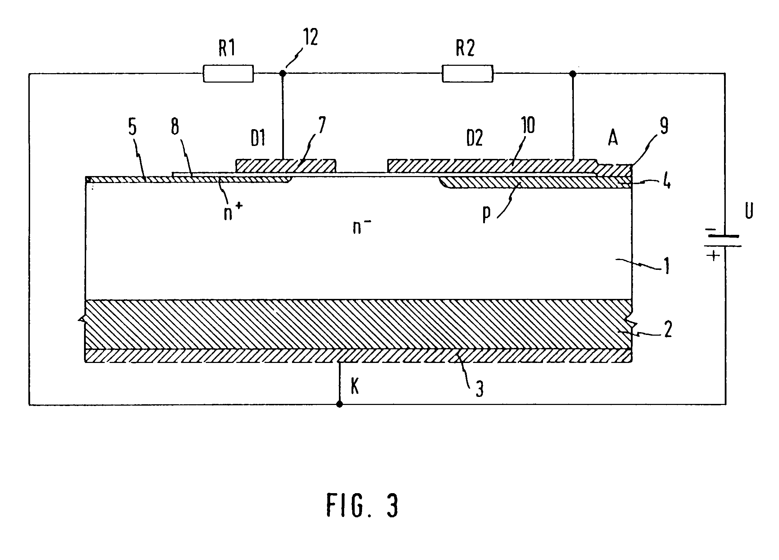

In Figur 3 ist eine Ausführungsform gezeigt, bei der der pn⁻-Übergang zwischen dem hochohmigen Kollektorgebiet 1 und dem p-dotierten Basisgebiet 4 mittels einer zweiten metallischen Deckelektrode D2 passiviert ist. Die beiden Deckelektroden D1 und D2 berühren sich nicht, so daß von einer geteilten Deckelektrode gesprochen werden kann. Dabei ist die Metallisierung 10, die die Deckelektrode D2 bildet, mit der Basismetallisierung des Transistors identisch. Es ist jedoch auch möglich, die Metallisierung 10 auf Emitterpotential zu legen, wobei jedoch sichergestellt sein muß, daß die Metallisierungen 7 und 10 galvanisch getrennt sind. Auch bei dieser Ausführung kann kein Anreicherungsdurchbruch auftreten, so daß die maximal erreichbare Durchbruchsspannung U nur vom Verarmungsdurchbruch U1 und dem Spannungsteilerverhältnis entsprechend obiger Gleichung (1) bestimmt ist.

Für den Fall, daß man die beiden Deckelektroden D1 und D2 elektrisch miteinander verbindet und an den Spannungsteiler R1, R2 schaltet, erhält man ein zur herkömmlichen Deckelektrode D (Figur 1) völlig identisches Durchbruchsverhalten, insbesondere ist dann die maximal erreichbare Durchbruchsspannung wieder die Summe der Anreicherungsdurchbruchsspannung und der Verarmungsdurchbruchsspannung (U1 + U2).

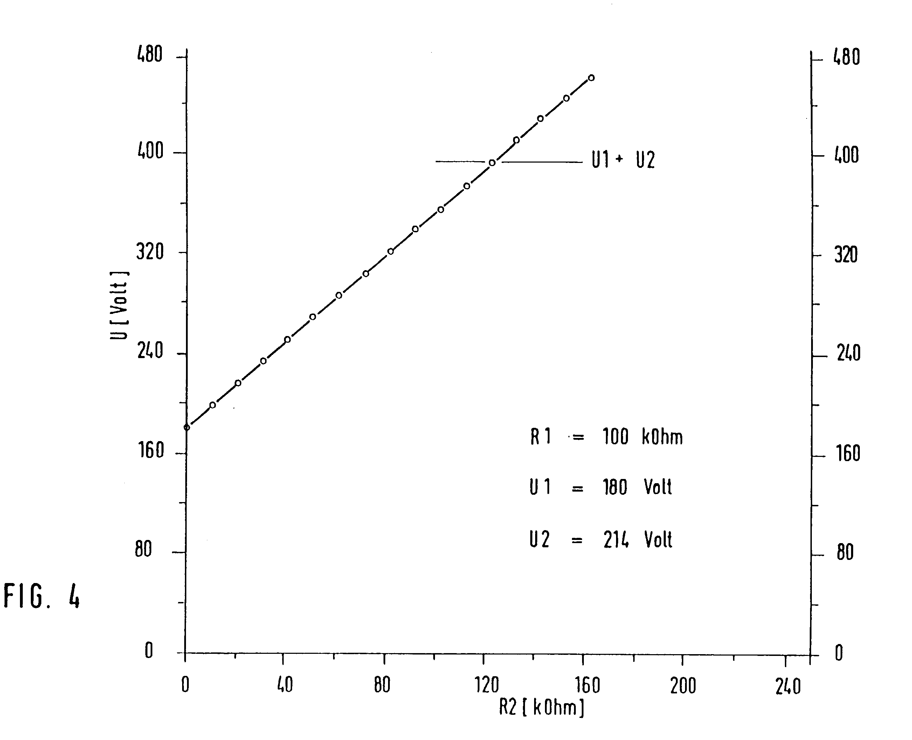

In Figur 4 ist die Abhänigkeit der Durchbruchsnung einer Halbleiteranordnung mit geteilter Deckelektrode (D1 und D2) vom Spannungsteilerverhältnis dargestellt. Die Verarmungsdurchbruchsspannung U1 beträgt dabei 180 V und die Anreicherungsdurchbruchsspannung U2 beträgt 214 V. Der Widerstand R1 ist 100 kΩ. Die Durchbruchsspannung U zwischen den Punkten A und K ist als Funktion vom Spannungsteilerwiderstand R2 aufgetragen. Die Durchbruchsspannung U hat den von Gleichung (1) beschriebenen Verlauf. Für R2 > 125 kΩ werden Durchbruchsspannungen erreicht, die größer als die Summe der Verarmungsdurchbruchsspannung und Anreicherungsdurchbruchsspannung sind. Das dargestellte Beispiel geht von einer Anordnung gemäß Figur 2 aus, wobei die Widerstände R1, R2 extern angeschlossen sind.

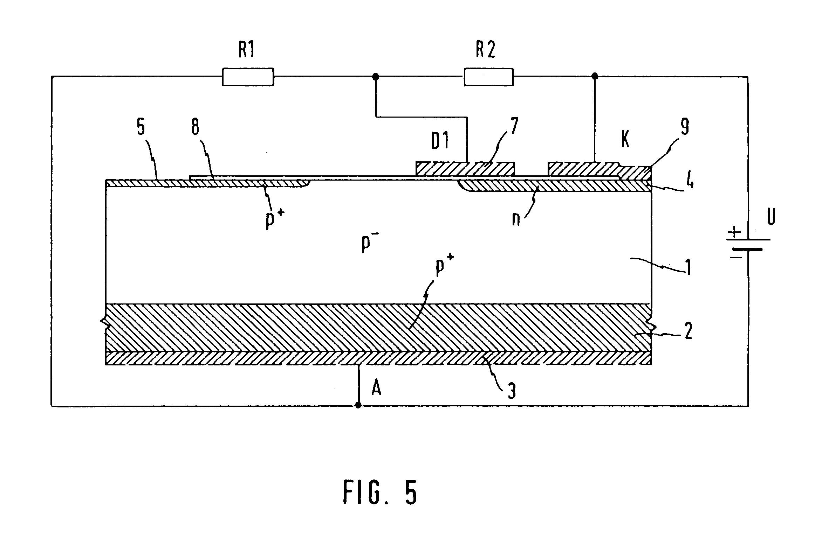

Die vorliegende Erfindung ist nicht auf npn-Transistoren beschränkt, sondern kann auch bei pnp-Transistoren Anwendung finden, wie dies in Figur 5 ersichtlich ist. Dabei ist das hochohmige Kollektorgebiet 1 schwach p-dotiert und die Zone 4 vom entgegengesetzten Leitfähigkeitstyp ist n-dotiert und bildet wiederum das Basisgebiet eines Transistors. Im Abstand von dieser ersten Zone 4 befindet sich an der Hauptoberfläche 6 eine zweite, hochdotierte Zone 5 mit einer Ausbuchtung 5A des gleichen Leitfähigkeitstyps wie das das Kollektorgebiet 1 bildende Substrat. Die p-dotierte zweite Zone 5 ist jedoch hochdotiert, ebenso wie die Unterseite 2 des Substrats. Auch bei der Darstellung in Figur 5 ist der Übersichtlichkeit wegen wiederum das Emittergebiet nicht eingezeichnet.

Die Deckelektrode D1 befindet sich bei dieser Ausführungsform über dem Kollektor-Basisübergang 1, 4. Die Polarität der Sperrspannung U ist entgegengesetzt zu den zuvor beschriebenen Ausführungen.

Analog zu Figur 3 kann auch bei der Ausführung gemäß Figur 5 der Übergang vom Kollektorgebiet 1 zur hochdotierten Zone 5 mit auf Kollektorpotential befindlichem Metall überdeckt sein. Beim Anlegen einer Sperrspannung zwischen A und K wird die im Fall eines pnp-Transistors stabile -Anreicherungdurchbruchsspannung U2 durch den Spannungsteiler hochtransformiert. Die Durchbruchsspannung U zwischen A und K ergibt sich somit bei pnp-Transistoren aus folgender Gleichung:

$$U = U2 * (1 + R1 / R2) \qquad (2)$$

Bei der monolithischen Integration des Spannungsteilers, der auch abgleichbar ausgeführt sein kann, darf es keine Bereiche geben, in denen ein Anreicherungsdurchbruch auftritt.

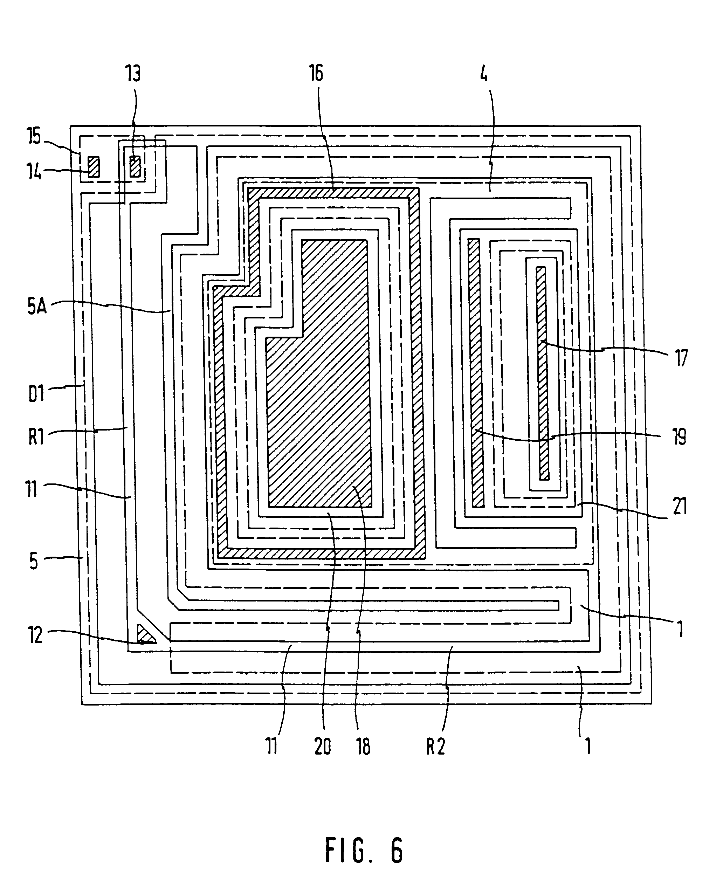

Anhand von Figur 6 bis 8 ist gezeigt, wie eine interne Spannungsbegrenzung mit integriertem Spannungsteiler an einem planaren npn-Darlingtontransistor realisiert werden kann. Dabei sind alle Metallisierungskanten als unterbrochene Linien eingezeichnet.

Figur 6 zeigt in der Draufsicht ein Beispiel mit fehlender Deckelektrode D2 analog zu Figur 2. Die Basismetallisierung des Endstufentransistors befindet sich vollständig innnerhalb des p-dotierten Basisgebietes 4. Ein Spannungsteiler 11 bildet eine von der Hauptoberfläche eindiffundierte langgestreckte p-leitende Zone. Der kollektorseitige Teil R1 des Spannungsteilers 11 ist von der Passivierungsschicht (8 in Figur 2) und der darüber hinweg verlaufenden Deckelektrode D1 überdeckt. An einer bestimmten Stelle 12 ist die Passivierungsschicht 8 unterhalb der Deckelektrode D1 entfernt. Das so gebildete Kontaktloch 12 schließt die Deckelektrode D1 an einer Stelle an den Spannungsteiler 11 an. Am kollektorseitigen Ende des Spannungsteilers ist ebenfalls ein Kontaktloch 13 geöffnet. Außerdem ist die als Stoppschicht dienende hochdotierte Kollektorschicht 5 an einer Stelle 14 kontaktierbar. Eine Metallisierungsbrücke 15 stellt eine elektrische Verbindung von Kollektorschicht und Spannungsteilerende her.

Das basisseitige Ende des Spannungsteilers mündet direkt in die p-dotierte Basiszone 4 der Endstufe des Darlingtontransistors. Der basisseitige Teil R2 des Spannungsteilers ist nicht unter das Deckelektrodenmetall D1 gelegt, um den Anreicherungsdurchbruch zu vermeiden. Weiter erkennt man die Kontaktierungsflächen für die Endstufenbasis 16, für die Treiberbasis 17, für den Endstufenemitter 18 und für den Treiberemitter 19. Der Endstufenemitter selber ist mit 20, der Treiberemitter mit 21 bezeichnet. Der Übersichtlichkeit halber sind nicht alle Details des Darlingtontransistors wie Ableitwiderstand des Endstufentransistors, Inversdiode etc. eingezeichnet. Da in der Anordnung nach Figur 6 bei Erreichen der Durchbruchsspannung auch das basisseitige Ende des Spannungsteilers (R2) seine Sperrfähigkeit verliert, wird die Durchbruchskennlinie stromabhängig. Um dies zu verhindern, wird das Oxid über dem hochohmingen Kollektorgebiet 1 in der Umgebung des Widerstandes R2 dicker ausgeführt. Dadurch wird die Verarmungsdurchbruchsspannung in diesem Bereich erhöht, so daß der Spannungsteilerwiderstand R2 seine Sperrfähigkeit behält.

Der Spannungsteilerwiderstand kann auch durch einen oder zwei gesonderte p-Dotierschritte eingebracht werden. Dadurch lassen sich große Widerstände bzw. verschiedene Temperaturkoeffizienten erzielen. Außerdem kann der Spannungsteilerwiderstand abgleichbar ausgeführt werden.

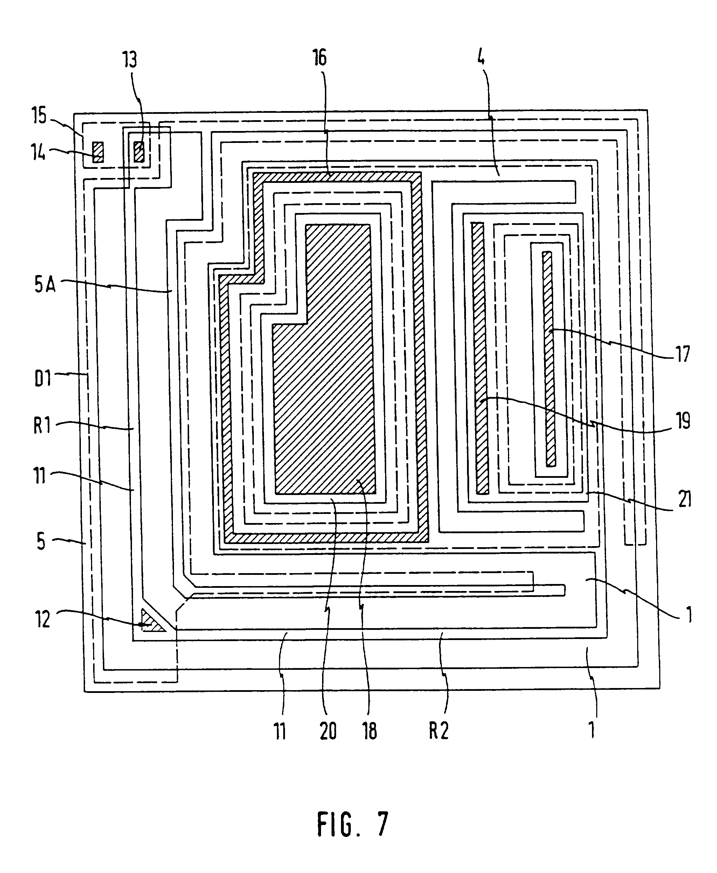

Eine weitere einfache Möglichkeit stromunabhängige Durchbruchskennlinien zu erhalten, ohne die Maßnahme der Oxiddickenverringerung anzuwenden, ist in dem Ausführungsbeispiel Figur 7 gezeigt. Dabei wird die D1-Metallisierung in Bereichen des Spannungsteilerwiderstandes R2 weggelassen. Somit tritt in diesem Bereich kein Verarmungsdurchbruch auf und der Widerstand R2 veliert seine Sperrfähigkeit nicht.

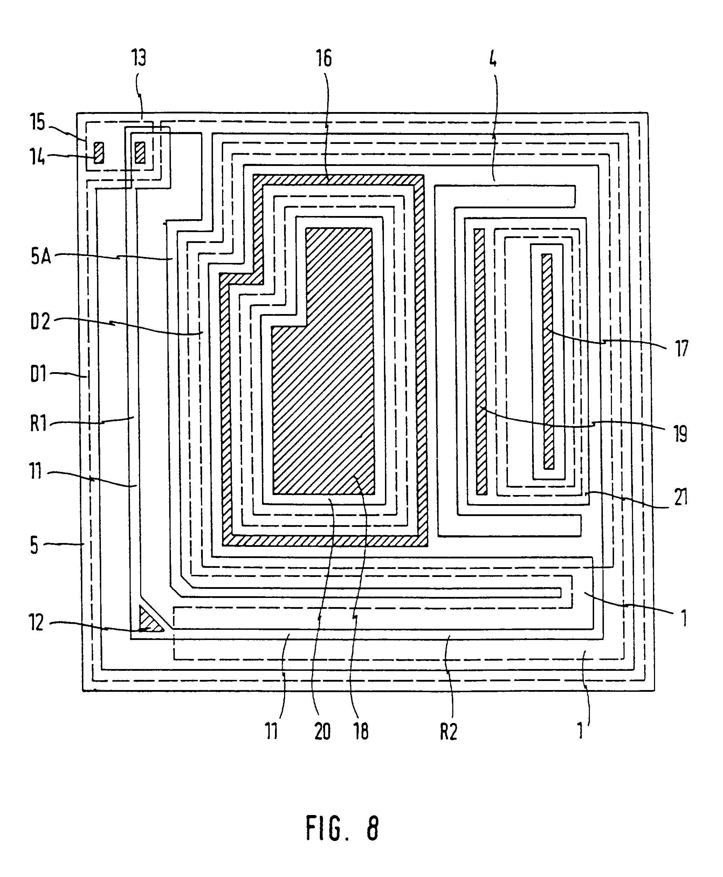

Figur 8 zeigt ein Beispiel mit zusätzlicher Deckelektrode D2 (geteilte Deckelektrode). Der Basis-Kollektor-Übergang (4, 1) ist dann fast vollständig mit von Oxid getrenntem Metall überdeckt.

**Patentansprüche**

1. Monolithisch integrierte Halbleiteranordnung mit wenigstens einem pn-Übergang, der durch das einen bestimmten Leitfähigkeitstyp aufweisende Substrat und eine in die Hauptoberfläche des Substrat eindiffundierte erste Zone entgegengesetzten Leitfähigkeitstyps gebildet ist, mit einer im Abstand von dieser ersten Zone in der Hauptoberfläche eindiffundierten zweiten, hochdotierten Zone des gleichen Leitfähigkeitstyps wie das Substrat und mit wenigstens einer die Hauptoberfläche teilweise bedeckenden Passivierungsschicht, auf der mindestens eine metallische Deckelektrode aufgebracht ist, die an ein Spannungspotential angeschlossen ist, dessen Wert zwischen dem Potentialwert der ersten Zone und dem einer an der Unterseite des Substrats ausgebildeten Metallisierung liegt, dadurch gekennzeichnet, daß bei einer Halbleiteranordnung mit n-dotiertem Substrat (1) die Deckelektrode (D1) im Abstand von der ersten, p-dotierten Zone (4) angeordnet ist und die n-dotierte zweite Zone (5) sowie einen Teil der an die zweite Zone (5) angrenzenden Substratoberfläche zwischen der ersten und der zweiten Zone überdeckt, während bei einer Halbleiteranordnung mit p-dotiertem Substrat die Deckelektrode (D1) im Abstand von der zweiten, p-dotierten Zone (5) angeordnet ist und die n-dotierte erste Zone (4) sowie einen Teil der an die erste Zone (4) angrenzenden Substratoberfläche zwischen der ersten und der zweiten Zone überdeckt.

2. Halbleiteranordnung nach Anspruch 1, dadurch gekennzeichnet, daß eine Basismetallisierung (9) der als npn-Transistor ausgebildeten Halbleiteranordnung eine zweite Deckelektrode (D2) bildet, die den Randbereich zwischen Basiszone (4) und angrenzendem Substrat (1) überdeckt.

## Claims

1. Monolithic integrated semiconductor arrangement having at least one pn junction, which is formed by the substrate, which has a specific conductivity type, and a first region of opposite conductivity type which is diffused into the main surface of the substrate, having a second, heavily doped region of the same conductivity type as the substrate, which region is diffused into the main surface at a distance from the said first region, and having at least one passivation layer, which partly covers the main surface and on which at least one metallic covering electrode is applied, which is connected to a voltage potential having a value between the potential value of the first region and that of a metallization layer formed on the underside of the substrate, characterized in that, in the case of a semiconductor arrangement having an n-doped substrate (1), the covering electrode (D1) is arranged at a distance from the first, p-doped region (4) and covers the n-doped second region (5) as well as part of the substrate surface, adjoining the second region (5), between the first and the second region, while in the case of a semiconductor arrangement having a p-doped substrate, the covering electrode (D1) is arranged at a distance from the second, p-doped region (5) and covers the n-doped first region (4) as well as part of the substrate surface, adjoining the first region (4), between the first and the second region.

2. Semiconductor arrangement according to Claim 1, characterized in that a base metallization layer (9) of the semiconductor arrangement, which is constructed as an npn transistor, forms a second covering electrode (D2) which covers the edge region between the base region (4) and the adjoining substrate (1).

## Revendications

1. Dispositif semi-conducteur intégré monolithique comportant au moins une jonction pn formée par le substrat ayant un certain type de conductivité et une première zone diffusée dans la surface principale du substrat et ayant une conductivité de type opposé, avec à distance de cette première zone, dans la surface principale, une seconde zone, diffusée, fortement dopée et ayant le même type de conductivité que le substrat, et au moins une couche de passivation recouvrant partiellement la surface principale, sur laquelle est appliquée au moins une électrode de recouvrement métallique raccordée à un potentiel dont la valeur est comprise entre le potentiel de la première zone et celui d'une métallisation réalisée sur la face inférieure du substrat, caractérisé en ce? que pour un dispositif semi-conducteur à substrat à dopage n (1)? l'électrode de recouvrement (D1) est prévue à distance de la première zone (4) à dopage p et recouvre la seconde zone (5) à dopage n ainsi qu'une partie de la surface du substrat adjacentE à la seconde zone (5), entre la première et la seconde zone, et? dans le cas d'un dispositif semi-conducteur à substrat à dopage p, l'électrode de recouvrement (D1) est située à distance de la seconde zone (5) à dopage p et recouvre la première zone (4) à dopage n ainsi qu'une partie de la surface du substrat adjacente à la première zone (4), entre la première et la seconde zone.

2. Dispositif semi-conducteur selon la revendication 1, caractérisé en ce qu'une métallisation de base (9) du dispositif semi-conducteur en forme de transistor npn constitue une seconde électrode de recouvrement (D2) qui recouvre la zone de bord comprise entre la zone de base (4) et le substrat adjacent (1).

FIG. 1

FIG. 2

EP 0 561 809 B1

FIG. 3

R 1 = 100 kOhm

U 1 = 180 Volt

U 2 = 214 Volt

U1 + U2

R2 [ kOhm]

U [ Volt ]

FIG. 4

FIG. 5

EP 0 561 809 B1

FIG. 6

FIG. 7

FIG. 8